# EUROPÄISCHE PATENTSCHRIFT

(11) **EP 4 288 787 B1**
(45) Veröffentlichungstag und Bekanntmachung des Hinweises auf die Patenterteilung: **14.05.2025**
(21) Anmeldenummer: 22702970.9
(22) Anmeldetag: 01.02.2022
(51) Int. Cl.: G01R 19/165, B25F 5/00, H02H 3/24, H02H 11/00

(54) **VORRICHTUNG UND VERFAHREN ZUR ERKENNUNG EINES SPANNUNGSABFALLS**
DEVICE AND METHOD FOR DETECTING A VOLTAGE DROP
DISPOSITIF ET PROCÉDÉ DE DÉTECTION D'UNE CHUTE DE TENSION

(30) Priorität: 02.02.2021 DE 102021102304
(43) Veröffentlichungstag der Anmeldung: 13.12.2023
(73) Patentinhaber: Metabowerke GmbH, 72622 Nürtingen (DE)
(72) Erfinder: BECK, Tobias, 72639 Neuffen (DE)
(74) Vertreter: Lorenz, Matthias
(86) Internationale Anmeldenummer: PCT/EP2022/052316
(87) Internationale Veröffentlichungsnummer: WO 2022/167405

(56) Entgegenhaltungen:
- EP-A1- 3 306 767
- EP-A1- 3 441 192
- DE-A1- 10 222 175
- DE-A1- 102018 127 502
- DE-A1- 19 645 144
- US-A- 5 357 395

## Beschreibung

Die Erfindung betrifft eine Vorrichtung zur Erkennung eines Spannungsabfalls zwischen einem Anodenanschluss und einem Kathodenanschluss, aufweisend einen Kontrollkondensator, eine Messeinrichtung, eine Entladeschaltung und eine Steuereinrichtung.

Die Erfindung betrifft außerdem eine Elektrowerkzeugmaschine, insbesondere eine akkubetriebene Elektrowerkzeugmaschine, mit einer Vorrichtung zur Erkennung eines Spannungsabfalls.

Die Erfindung betrifft auch ein Verfahren zur Erkennung eines Spannungsabfalls zwischen einem Anodenanschluss und einem Kathodenanschluss, wonach zur Erkennung des Spannungsabfalls der Ladezustand eines Kontrollkondensator ausgewertet wird.

Die Erfindung betrifft weiter ein Computerprogramm zur Ausführung des Verfahrens durch eine Steuereinrichtung.

Bei elektrischen Einrichtungen besteht mitunter der Bedarf, einen Spannungsabfall festzustellen (insbesondere einen Spannungsabfall einer Versorgungsspannung der elektrischen Einrichtung oder von Komponenten der elektrischen Einrichtung), um beispielsweise geeignete Maßnahmen zur Begrenzung schadhafter Wirkungen des Spannungsabfalls und/oder vorbeugende Maßnahmen zur Verhinderung eines erneuten Spannungsabfalls einzuleiten, oder um den Spannungsabfall zu dokumentieren und/oder einen Benutzer über den Vorfall zu informieren.

Das nachträgliche Feststellen eines Spannungsabfalls, beispielsweise nachdem eine Versorgungsspannung wiederhergestellt wurde, ist technisch nicht immer einfach umzusetzen, insbesondere da die elektronischen Komponenten der Einrichtung, die zur Erkennung des Spannungsabfalls in Frage kommen können (beispielsweise eine Steuereinrichtung, wie ein Mikroprozessor etc.), in der Regel ebenfalls von dem Spannungsabfall betroffen sind.

Das Feststellen eines Spannungsabfalls kann unter anderem bei sicherheitskritischen Einrichtungen, wie beispielsweise Alarmanlagen, Gefahrenmeldeanlagen und Einrichtungen zur Zugangsbeschränkung, und insbesondere auch bei motorisch angetriebenen Einrichtungen, wie zum Beispiel elektrisch angetriebene Fahrzeuge oder Elektrowerkzeugmaschinen, angezeigt sein.

Bei Elektrowerkzeugmaschinen und bei elektrisch angetriebenen Fahrzeugen besteht eine besondere Gefahr darin, dass die Elektrowerkzeugmaschine oder das Fahrzeug unbeabsichtigt in Gang gesetzt wird, nachdem die Spannung wiederhergestellt wurde.

Dies kann bei Elektrowerkzeugmaschinen insbesondere dann der Fall sein, wenn der manuell betätigbare Betriebsschalter der Elektrowerkzeugmaschine zum Ein- und Ausschalten der Elektrowerkzeugmaschine in der Einschaltstellung feststellbar ist. In solchen Fällen kann es passieren, dass der Betriebsschalter in seiner Einschaltstellung steht, wenn der Anwender die Elektrowerkzeugmaschine an eine Spannungsquelle anschließt. Alternativ kann eine unbeabsichtigte Inbetriebnahme einer Elektrowerkzeugmaschine auch dadurch erfolgen, dass während des Betriebs der Elektrowerkzeugmaschine aufgrund eines Fehlerfalls, beispielsweise aufgrund eines überhitzten Akkupacks, die Versorgungsspannung vorrübergehend ausfällt und anschließend unerwartet wieder verfügbar gemacht wird, z. B. wenn sich das Akkupack wieder ausreichend abgekühlt hat.

Die unbeabsichtigte und damit gegebenenfalls auch unbeaufsichtigte Inbetriebnahme der Elektrowerkzeugmaschine oder eines Elektrofahrzeugs kann sowohl für den Anwender als auch für andere Personen, die sich im unmittelbaren Umfeld befinden, hochgradig gefährlich sein und zudem kostenträchtige Schäden an der Maschine bzw. dem Fahrzeug hervorrufen. Um die in diesem Fall auftretenden Gefahren für den Anwender und seine Umgebung zu umgehen kann eine Überwachung eines Spannungsabfalls zur Bereitstellung eines Wiederanlaufschutzes angezeigt sein.

Aus dem Stand der Technik ist es bereits bekannt, bei Elektrowerkzeugmaschinen, insbesondere bei ackubetriebenen Elektrowerkzeugmaschinen, einen entsprechenden Wiederanlaufschutz vorzusehen. Bei dieser Lösung verhindert ein Sicherheitssystem das Anlegen elektrischer Leistung an den Motor, wenn der Betriebsschalter der Elektrowerkzeugmaschine beim Verbinden der Elektrowerkzeugmaschine mit der Spannungsquelle in seiner Einschaltstellung betätigt ist. Eine unbeabsichtigte Inbetriebnahme der Elektrowerkzeugmaschine kann dadurch verhindert werden. In der Regel ist hierzu eine Sicherheitsschaltung vorgesehen, die mit dem Betriebsschalter der Elektrowerkzeugmaschine verbunden ist und dessen Schaltstellung ermittelt. Die Sicherheitsschaltung weist ferner in der Regel eine Überwachungsschaltung auf, um eine nach ausgefallender Versorgungsspannung wieder hergestellte Versorgung der Elektrowerkzeugmaschine zu ermitteln. Ein derartiger Wiederanlaufschutz ("Anlaufsperre") für eine akkubetriebene Elektrowerkzeugmaschine ist beispielsweise in der DE 10 2009 046 116 A1 beschrieben.

In der Praxis werden in Elektrowerkzeugmaschinen, insbesondere auch in akkubetriebenen Elektrowerkzeugmaschinen, Pufferkondensatoren eingesetzt, um Überspannungen, beispielsweise bei einer Taktung einer Elektrowerkzeugmaschine mit bürstenlosem Gleichstrommotor, derart zu minimieren, dass alle Leistungsschalter der Elektrowerkzeugmaschine innerhalb ihres spezifizierten Bereichs betrieben werden können. Hierzu werden in der Regel hochkapazitive Pufferkondensatoren mit nur sehr geringen äquivalenten Serienwiderständen (sogenannte "Low-ESR"-Kondensatoren) an den Akkupackanschlüssen bzw. zwischen dem zur elektrischen Versorgung der Elektrowerkzeugmaschine vorgesehenen Anodenanschluss und Kathodenanschluss eingesetzt. Dies ist jedoch für die Erkennung eines Spannungsabfalls bzw. in Kombination mit einer Wiederanlaufschutzvorrichtung problematisch, da die Pufferkondensatoren aufgrund ihrer hohen Kapazität und ihres geringen Serienwiderstands vorübergehend selbst wie eine Energiequelle wirken können. Ein Entfernen des Akkupacks oder ein Störungsfall des Akkupacks kann somit aufgrund der Pufferung der Versorgungsspannung verschleiert werden. Somit kann es vorkommen, dass der Motor der Elektrowerkzeugmaschine nach einem Entfernen eines oder mehrerer Akkupacks zunächst ausfällt, die Wiederanlaufschutzvorrichtung jedoch nach wie vor eine ausreichende Spannung durch den Pufferkondensator erhält, wodurch diese das Wegfallen der Versorgungsspannung nicht wahrzunehmen vermag. Infolge kann bei einem Wiederherstellen der tatsächlichen Versorgungsspannung der Wiederanlaufschutz bei betätigtem Betriebsschalter nicht bereitgestellt werden.

Ferner sind die bekannten Vorrichtungen zur Erkennung eines Spannungsabfalls mitunter nicht verlässlich verwendbar, wenn mehrere Akkupacks gleichzeitig in die Elektrowerkzeugmaschine einsetzbar sind. Auch sind die bekannten Vorrichtungen mitunter nur zur Verwendung mit bestimmten Akkupacktypen geeignet.

Zum technologischen Hintergrund sei außerdem noch auf die folgenden Druckschriften verwiesen:
Die US 5,357,395 A betrifft eine Schaltung, ein System und ein Verfahren zum Schutz eines elektronischen Geräts vor Fehlfunktionen, die durch Unterspannungsbedingungen der Stromversorgung verursacht werden. Die EP 3 306 767 A1 betrifft ebenfalls eine Schaltungsschutzanordnung, insbesondere eine Schaltungsschutzanordnung zur Verwendung in einem Fahrzeug zum Schutz einer elektronischen Schaltung. Die DE 196 45 144 A1 betrifft eine Unterspannungs- und Power-on-Reset-Schaltung für einen Mikroprozessor mit einer Spannungsstabilisierschaltung, die an eine ungeregelte Spannungsversorgung angeschlossen ist. Die DE 10 2018 127 502 A betrifft eine Wiederanlaufschutzvorrichtung für eine akkubetriebene Elektrowerkzeugmaschine, umfassend einen Kontrollkondensator, eine Entladeschaltung, eine Messeinrichtung und eine Steuereinrichtung. Die EP 3 441 192 A1 betrifft ein Elektrowerkzeug, insbesondere mit einem Steuerungssystem und einer Vorrichtung zur Verhinderung eines gefährlichen Wiederanlaufs eines Elektrowerkzeugs, das sich bereits in einem EIN-Zustand befindet, wenn die Stromzufuhr eingeleitet wird.

In Anbetracht des bekannten Stands der Technik besteht die Aufgabe der vorliegenden Erfindung darin, eine Vorrichtung bereitzustellen, mit der die Erkennung eines Spannungsabfalls verlässlich möglich ist, und die sich vorzugsweise flexibel zur Verwendung in verschiedenen elektrischen Einrichtungen einsetzen lässt, insbesondere auch in Kombination mit einer gepufferten Versorgungsspannung und/oder mit mehreren Spannungsquellen.

Schließlich ist es auch Aufgabe der Erfindung, eine Elektrowerkzeugmaschine bereitzustellen, in die eine verbesserte Vorrichtung zur Erkennung eines Spannungsabfalls integriert ist, insbesondere zur Bereitstellung eines verlässlichen Wiederanlaufschutzes.

Außerdem ist es Aufgabe der Erfindung, ein Verfahren bereitzustellen, mit dem die Erkennung eines Spannungsabfalls verlässlich möglich ist, und das sich vorzugsweise flexibel zur Verwendung in verschiedenen elektrischen Einrichtungen einsetzen lässt, insbesondere auch in Kombination mit einer gepufferten Versorgungsspannung und/oder mit mehreren Spannungsquellen.

Es ist auch eine Aufgabe der Erfindung, ein vorteilhaftes Computerprogramm bereitzustellen.

Die Aufgabe wird für die Vorrichtung mit den in Anspruch 1 aufgeführten Merkmalen gelöst. Bezüglich der Elektrowerkzeugmaschine wird die Aufgabe durch die Merkmale des Anspruchs 8 gelöst. Betreffend das Verfahren wird die Aufgabe durch Anspruch 10 und für das Computerprogramm durch Anspruch 11 gelöst.

Die abhängigen Ansprüche und die nachfolgend beschriebenen Merkmale betreffen vorteilhafte Ausführungsformen und Varianten der Erfindung.

Es ist eine Vorrichtung zur Erkennung eines Spannungsabfalls zwischen einem Anodenanschluss und einem Kathodenanschluss vorgesehen.

Die Spannung bzw. die Potentialdifferenz zwischen dem Anodenanschluss und dem Kathodenanschluss wird nachfolgend mitunter auch als "Versorgungsspannung" bezeichnet. Grundsätzlich muss es sich allerdings nicht unbedingt um eine Versorgungsspannung handeln.

Der Anodenanschluss kann auch als "positiver" Anschlusspunkt bezeichnet werden. Der Kathodenanschluss kann auch als "negativer" Anschlusspunkt oder als "Masseanschluss" bzw. "Ground" bezeichnet werden.

Der Anodenanschluss und/oder der Kathodenanschluss kann als Teil der erfindungsgemäßen Vorrichtung verstanden werden, kann allerdings auch lediglich von der Vorrichtung überwacht werden, also nicht Teil der Vorrichtung sein.

Erfindungsgemäß weist die Vorrichtung einen Kontrollkondensator auf, dessen erste Elektrode mit dem Anodenanschluss und dessen zweite Elektrode mit dem Kathodenanschluss verbunden ist. Bei dem Kontrollkondensator kann es sich grundsätzlich um einen Kondensator beliebiger Bauart handeln.

Die Vorrichtung weist erfindungsgemäß eine Messeinrichtung auf, die eingerichtet ist, ein Entladesignal in Abhängigkeit einer zwischen dem Anodenanschluss und dem Kathodenanschluss erfassten Potentialdifferenz und einem ersten Schwellenwert für die Potentialdifferenz auf einer Entladesteuerleitung auszugeben. Vorzugsweise ist die Messeinrichtung hierzu mit dem Anodenanschluss und/oder dem Kathodenanschluss verbunden.

Die Potentialdifferenz zwischen dem Anodenanschluss und dem Kathodenanschluss kann in der Messeinrichtung insbesondere als Teiler der vollständigen Potentialdifferenz ermittelt werden (vorzugsweise über den nachfolgend noch genannten zweiten Spannungsteiler).

Erfindungsgemäß weist die Vorrichtung außerdem eine mit der Entladesteuerleitung verbundene Entladeschaltung auf, die eingerichtet ist, den Kontrollkondensator in Abhängigkeit von dem Entladesignal zu entladen.

Bei dem Entladesignal kann es sich um einen analogen oder digitalen Spannungswert handeln, der über die Entladesteuerleitung übertragen wird. Beispielsweise kann es sich bei dem Entladesignal um ein negatives Potential handeln, das dem Potential des Kathodenanschlusses zumindest angenähert ist, oder um ein positives Potential handeln, das dem Potential des Anodenanschlusses zumindest angenähert ist. Das Entladesignal kann allerdings vorzugsweise durch das Fehlen eines elektrischen Potentials auf der Entladesteuerleitung bereitgestellt werden, beispielsweise wenn die Entladesteuerleitung von der Messeinrichtung potentialfrei geschaltet wird ("floating"), während im Normalbetrieb, also bei ausreichender Potentialdifferenz zwischen dem Anodenanschluss und dem Kathodenanschluss, ein definiertes Potential (insbesondere ein negatives Potential, beispielweise das Potential des Kathodenanschlusses) auf der Entladesteuerleitung anliegt.

Erfindungsgemäß weist die Vorrichtung außerdem eine Steuereinrichtung auf, die eingerichtet ist, um den Spannungsabfall durch Auswertung des Ladezustands des Kontrollkondensators zu erkennen.

Die Steuereinrichtung kann als Mikroprozessor ausgebildet sein. Anstelle eines Mikroprozessors kann auch eine beliebige weitere Einrichtung zur Implementierung der Steuereinrichtung vorgesehen sein, beispielsweise eine oder mehrere Anordnungen diskreter elektrischer Bauteile auf einer Leiterplatte, eine speicherprogrammierbare Steuerung (SPS), eine anwendungsspezifische integrierte Schaltung (ASIC) oder eine sonstige programmierbare Schaltung, beispielsweise auch ein Field Programmable Gate Array (FPGA), eine programmierbare logische Anordnung (PLA) und/oder ein handelsüblicher Computer.

Es ist ein besonderer Vorteil der Erfindung, dass das Entladesignal durch direkte Überwachung der Potentialdifferenz zwischen dem Anodenanschluss und dem Kathodenanschluss ausgegeben wird. Dadurch kann beispielsweise die Notwendigkeit der Überwachung von Steuerleitungen der die Versorgungsspannung bereitstellenden Spannungsquelle entfallen, wodurch sich die Vorrichtung flexibel zur Verwendung mit beliebigen Spannungsquellen einsetzen lässt.

Dadurch, dass die Messeinrichtung bei der Erzeugung des Entladesignals den ersten Schwellenwert heranzieht, können außerdem etwaige Restspannungen durch eine Pufferung der Spannung, beispielsweise durch einen Pufferkondensator, vorteilhaft mitberücksichtigt und damit bei der Erzeugung des Entladesignals ausgeblendet werden.

Es kann vorgesehen sein, dass bei der Überwachung des Spannungsabfalls von der Steuereinrichtung keine Absolutwerte zum Vergleich gebracht werden, sondern der Abgleich des Ladezustands des Kontrollkondensators mit einem Teiler der tatsächlich anliegenden Versorgungsspannung erfolgt. Auf diese Weise können der Signalhub und die Detektiersicherheit verbessert sein.

Die Steuereinrichtung kann eingerichtet sein, um den Spannungsabfall nach der Wiederherstellung der Spannung, insbesondere unmittelbar bzw. baldmöglichst nach der Wiederherstellung der Spannung, zu erkennen.

In einer vorteilhaften Weiterbildung der Erfindung kann vorgesehen sein, dass der Anodenanschluss und/oder der Kathodenanschluss mit korrespondierenden Versorgungsanschlüssen einer externen Spannungsquelle verbindbar sind. Dabei kann es sich insbesondere um die Versorgungsanschlüsse eines oder mehrerer Akkupacks handeln.

Beispielsweise kann es sich bei dem Anodenanschluss und/oder dem Kathodenanschluss unmittelbar um den Anodenkontakt bzw. Kathodenkontakt einer entsprechenden Versorgungsschnittstelle, insbesondere eine Akkupackschnittstelle, handeln.

Die Erfindung eignet sich ganz besonders zur Verwendung mit mehreren Akkupacks, beispielsweise zwei, drei, vier oder noch mehr Akkupacks.

Unter einem Akkupack kann im Rahmen der Erfindung sowohl ein Akkumulator mit einer einzelnen Akkumulatorzelle (auch Sekundärzelle genannt), als auch ein zusammengeschaltetes Paket mit mehreren Ackumulatorzellen zu verstehen sein. Unter einem Akkupack kann im weitesten Sinne auch ein Speicher für elektrische Energie zu verstehen sein, der nicht oder nicht ausschließlich elektrochemisch aufgebaut ist, also zum Beispiel ein Kondensator. Im Sinne der Erfindung werden auch Batterien bzw. Batteriepacks, d. h. nicht wiederaufladbare Speicher für elektrische Energie, zu dem Begriff "Akkupack" gezählt.

Gemäß einer Weiterbildung der Erfindung kann vorgesehen sein, dass die erste Elektrode des Kontrollkondensators über einen ersten Spannungsteiler mit dem Anodenanschluss verbunden ist.

Dadurch, dass der Kontrollkondensator mit dem Anodenanschluss und mit dem Kathodenanschluss verbunden ist, lädt sich der Kontrollkondensator bei vorhandener Spannung zwischen Anodenanschluss und Kathodenanschluss auf. Bei einem Normalbetrieb der elektrischen Einrichtung ist schließlich davon auszugehen, dass der Ladezustand des Kontrollkondensators nach der ersten Aufladung konstant oder zumindest nahezu konstant bleibt. Dieser Normalzustand kann von der Steuereinrichtung erkannt werden. Weicht der Ladezustand des Kontrollkondensators hingegen von diesem Normalzustand ab, kann die Steuereinrichtung auf einen stattgefundenen Spannungsabfall schließen.

Um das Ladeverhalten des Kontrollkondensators zu kontrollieren bzw. um eine definierte Ladekurve vorzugeben, kann dem Kontrollkondensator die Spannung zwischen dem Anodenanschluss und dem Kathodenanschluss entsprechend dem Teilungsverhältnis eines ersten Spannungsteilers zugeführt werden. Auf diese Weise können die Ladedauer und die maximal erreichbare Ladespannung vorgegeben werden.

Der erste Spannungsteiler kann beispielsweise eingerichtet bzw. dimensioniert sein, dem Kontrollkondensator 1% bis 50% der Potentialdifferenz zwischen dem Anodenanschluss und dem Kathodenanschluss verfügbar zu machen, vorzugsweise 2% bis 40%, besonders bevorzugt 3% bis 30%, ganz besonders bevorzugt 4% bis 20%, noch weiter bevorzugt 5% bis 10%.

Beispielsweise kann der erste Spannungsteiler der ersten Elektrode des Kontrollkondensators ein Verhältnis von 27 zu 497 der Potentialdifferenz zwischen dem Anodenanschluss und dem Kathodenanschluss zur Verfügung stellen (insbesondere bei einer nominalen Versorgungsspannung von 36 Volt). Beispielsweise kann der erste Spannungsteiler der ersten Elektrode des Kontrollkondensators ein Verhältnis von 27 zu 267 der Potentialdifferenz zwischen dem Anodenanschluss und dem Kathodenanschluss zur Verfügung stellen (insbesondere bei einer nominalen Versorgungsspannung von 18 Volt oder 10,8 Volt).

Erfindungsgemäß weist die Messeinrichtung einen ersten gesteuerten Schalter auf.

Der Steuereingang des ersten gesteuerten Schalters ist über einen zweiten Spannungsteiler mit dem Anodenanschluss verbunden. Insbesondere auf diese Weise ist die Vorrichtung flexibel an verschiedene Gegebenheiten, beispielsweise auch an einen optional vorhandenen Pufferkondensator, anpassbar.

Der zweite Spannungsteiler kann beispielsweise eingerichtet bzw. dimensioniert sein, dem Steuereingang des ersten gesteuerten Schalters 1% bis 50% der Potentialdifferenz zwischen dem Anodenanschluss und dem Kathodenanschluss verfügbar zu machen, vorzugsweise 2% bis 40%, besonders bevorzugt 3% bis 30%. Beispielsweise kann der zweite Spannungsteiler dem Steuereingang des ersten gesteuerten Schalters ein Verhältnis von 47 zu 447 der Potentialdifferenz zwischen dem Anodenanschluss und dem Kathodenanschluss zur Verfügung stellen. Die vorstehenden Werte eignen sich insbesondere bei einer nominalen Versorgungsspannung von 36 Volt.

Der zweite Spannungsteiler kann beispielsweise aber auch eingerichtet bzw. dimensioniert sein, dem Steuereingang des ersten gesteuerten Schalters 4% bis 20% der Potentialdifferenz zwischen dem Anodenanschluss und dem Kathodenanschluss verfügbar zu machen, oder auch 5% bis 10%. Beispielsweise kann der zweite Spannungsteiler dem Steuereingang des ersten gesteuerten Schalters ein Verhältnis von 100 zu 333 der Potentialdifferenz zwischen dem Anodenanschluss und dem Kathodenanschluss zur Verfügung stellen. Die vorstehenden Werte eignen sich insbesondere bei einer nominalen Versorgungsspannung von 18 Volt oder 10,8 Volt.

Der gesteuerte Schalter kann eingerichtet sein, zusammen mit dem ersten Spannungsteiler den ersten Schwellenwert festzulegen.

In einer Weiterbildung der Erfindung kann vorgesehen sein, dass der erste Schwellenwert 10% bis 90% der nominalen Potentialdifferenz zwischen dem Anodenanschluss und dem Kathodenanschluss beträgt, vorzugsweise 20% bis 80% beträgt und besonders bevorzugt 30% bis 70% beträgt.

Erfindungsgemäß ist der erste gesteuerte Schalter ausgebildet, die Entladesteuerleitung niederohmig mit dem Kathodenanschluss zu verbinden, wenn das an dem Steuereingang anliegende Eingangspotential den ersten Schwellenwert überschreitet.

Erfindungsgemäß ist vorgesehen, dass der erste gesteuerte Schalter ausgebildet ist, die Entladesteuerleitung von dem Kathodenanschluss zu trennen (bzw. hochohmig zu schalten), wenn das an dem Steuereingang anliegende Eingangspotential den ersten Schwellenwert unterschreitet.

Somit kann das Entladesignal vorzugsweise erzeugt werden, indem die Entladesteuerleitung bei einem Normalbetrieb, also bei ausreichender Spannungsversorgung, das Potential des Kathodenanschlusses trägt bzw. zumindest annähernd das Potential des Kathodenanschlusses trägt und bei einem Spannungsabfall potentialfrei geschaltet ist. Grundsätzlich kann allerdings auch vorgesehen sein, dass das Entladesignal durch ein definiertes Potential auf der Entladesteuerleitung bereitgestellt wird.

Erfindungsgemäß ist vorgesehen, dass die Entladeschaltung einen zweiten gesteuerten Schalter aufweist.

Der Steuereingang des zweiten gesteuerten Schalters ist mit der Entladesteuerleitung verbunden. Der zweite gesteuerte Schalter ist ausgebildet, die erste Elektrode des Kontrollkondensators niederohmig mit der zweiten Elektrode des Kontrollkondensators zu verbinden, wenn die Entladesteuerleitung von dem Kathodenanschluss getrennt ist (insbesondere wenn die Entladesteuerschaltung potentialfrei ist).

Es kann optional vorgesehen sein, dass die Entladesteuerleitung einen zwischen der Messeinrichtung und der Entladeschaltung angeordneten Serienwiderstand aufweist. Der Serienwiderstand der Entladesteuerleitung kann beispielsweise 1 kΩ bis 100 kΩ betragen, beispielsweise 47 kΩ.

Erfindungsgemäß ist vorgesehen, dass der Steuereingang des zweiten gesteuerten Schalters über einen Pullup-Widerstand mit dem Anodenanschluss verbunden ist.

Durch den Pullup- Widerstand kann auf vorteilhafte Weise ein auf Potentialfreiheit basierendes Entladesignal verwendbar sein. Der Pullup-Widerstand kann beispielsweise 1 MΩ oder mehr, beispielsweise 4,7 MΩ betragen.

Insbesondere kann vorgesehen sein, dass der Pullup-Widerstand hochohmiger ausgebildet ist, als der Serienwiderstand der Entladesteuerleitung. Beispielsweise kann der Serienwiderstand 4,7 kΩ und der Pullup-Widerstand 4,7 MΩ betragen.

In einer vorteilhaften Weiterbildung der Erfindung kann vorgesehen sein, dass der erste gesteuerte Schalter und/oder der zweite gesteuerte Schalter als Halbleiterschalter, insbesondere als MOSFET (Metall-Oxid-Halbleiter-Feldeffekttransistor, "Metal-Oxide-Semiconductor Field-Effect Transistor"), vorzugsweise als n-Kanal-MOSFET ausgebildet sind. Auch ein p-Kanal-MOSFET kann gegebenenfalls vorgesehen sein.

Grundsätzlich kann allerdings ein beliebiger gesteuerter Schalter vorgesehen sein, insbesondere jedoch ein Halbleiterschalter. Beispielsweise kann auch vorgesehen sein, dass der gesteuerte Schalter als Bipolartransistor ausgebildet ist. Die Bauart des gesteuerten Schalters ist grundsätzlich nicht einschränkend für die vorliegende Erfindung.

In einer vorteilhaften Weiterbildung der Erfindung kann vorgesehen sein, dass die Steuereinrichtung eine Komparatoreinheit aufweist, die eingerichtet ist, um den Ladezustand des Kontrollkondensators mit einem zweiten Schwellenwert für die Potentialdifferenz zwischen dem Anodenanschluss und dem Kathodenanschluss zu vergleichen, wobei der Spannungsabfall erkannt wird, wenn der Ladezustand kleiner ist als der zweite Schwellenwert.

Die Auswertung des Ladezustands des Kontrollkondensators kann vorzugsweise digital erfolgen. Beispielsweise kann die Komparatoreinheit als digitale Schaltung oder als digitales Softwaremodul ausgebildet sein.

Der Ladezustand, insbesondere das Potential der ersten Elektrode des Kontrollkondensators, kann der Steuereinrichtung vorzugsweise über einen ersten Analog-Digital-Wandler zugeführt werden.

Der zweite Schwellenwert kann vorzugsweise eine relative Potentialdifferenz in der Art eines Teilers der tatsächlichen Versorgungsspannung sein und der Steuereinrichtung beispielsweise über einen zweiten Analog-Digital-Wandler, ausgehend von einem dritten Spannungsteiler, zugeführt werden. Das Teilerverhältnis des dritten Spannungsteilers entspricht vorzugsweise dem Teilerverhältnis des ersten Spannungsteilers.

In einer vorteilhaften Weiterbildung der Erfindung kann vorgesehen sein, dass der zweite Schwellenwert 1% bis 95% der nominalen Potentialdifferenz zwischen dem Anodenanschluss und dem Kathodenanschluss beträgt, vorzugsweise 5% bis 50% beträgt, beispielsweise 5% bis 10% beträgt.

Die Steuereinrichtung kann eingerichtet sein, den Ladezustand des Kontrollkondensators unmittelbar nach einem Bootvorgang bzw. nach Inbetriebnahme der Steuereinrichtung nach Herstellung einer ausreichenden Versorgungsspannung für die Steuereinrichtung zu erfassen.

Es kann vorgesehen sein, dass die Steuereinrichtung eingerichtet ist, um den Ladezustand des Kontrollkondensators über einen definierten Zeitraum zu überwachen. Somit kann auch das Ladeverhalten des Kontrollkondensators erfasst werden und beispielsweise ein gerade stattfindender Ladevorgang erkennbar sein, der auf einen zuvor stattgefundenen Spannungsverlust schließen lässt.

Die Erfindung betrifft auch eine Elektrowerkzeugmaschine, insbesondere eine akkubetriebene Elektrowerkzeugmaschine, aufweisend einen Anodenanschluss und einen Kathodenanschluss zur elektrischen Versorgung, sowie eine Vorrichtung gemäß den vorstehenden und nachfolgenden Ausführungen zur Erkennung eines Spannungsabfalls zwischen dem Anodenanschluss und dem Kathodenanschluss.

Die vorgeschlagene Vorrichtung kann sich ganz besonders zur Verwendung mit einer Elektrowerkzeugmaschine eignen. Grundsätzlich kann sich die Vorrichtung allerdings zur Verwendung mit einer beliebigen elektrischen Einrichtung eignen, bei der die Erkennung eines Spannungsabfalls vorteilhaft ist, insbesondere auch bei einem elektrisch angetriebenen Fahrzeug.

In einer Weiterbildung kann vorgesehen sein, dass die Vorrichtung als Komponente einer Wiederanlaufschutzeinrichtung ausgebildet ist oder eine Wiederanlaufschutzeinrichtung aufweist. Die Erfindung eignet sich besonders gut zur Verwendung mit einer Wiederanlaufschutzeinrichtung.

Insbesondere kann vorgesehen sein, dass die Elektrowerkzeugmaschine eine Wiederanlaufschutzeinrichtung zum Schutz eines unkontrollierten Wiederanlaufens der Elektrowerkzeugmaschine nach einem Spannungsabfall aufweist, wobei die Wiederanlaufschutzeinrichtung zur Erkennung des Spannungsabfalls mit der Vorrichtung kommunikationsverbunden ist oder die Vorrichtung umfasst.

Vorzugsweise ist der Elektromotor der Elektrowerkzeugmaschine als bürstenloser Gleichstrommotor ausgebildet (BLDC-Technik). Die vorgeschlagene Vorrichtung zur Erkennung des Spannungsabfalls eignet sich für diese Technik besonders gut. Wird beispielsweise eines oder werden mehrere Akkupacks von der Elektrowerkzeugmaschine abgezogen, sinkt die Spannung der Maschinenelektronik bei der BLDC-Technik in der Regel nicht auf 0 Volt zurück, da entsprechende Pufferkondensatoren mit beispielsweise bis zu 5 Volt Restladung vorgesehen sind. Um dennoch ein Wiederanlaufschutzevent zu detektieren ist es durch die vorgeschlagene Vorrichtung möglich, den Einfluss der Kondensatorspannung auszublenden.

Die vorgeschlagene Vorrichtung eignet sich auch vorteilhaft, wenn ein Akkupack schräg bzw. nicht korrekt aufgeschoben oder von mehreren Akkupacks nur beispielsweise eines in die Elektrowerkzeugmaschine eingesetzt wird. Die Erfindung eignet sich demnach besonders gut für beispielsweise akkubetriebene Winkelschleifer, die häufig von zumindest zwei in Serie geschalteten Akkupacks betrieben werden.

Die Elektrowerkzeugmaschine kann einen Betriebsschalter zum wahlweise ein- oder ausschalten des Elektromotors aufweisen. Optional kann der Betriebsschalter in der eingeschalteten und/oder ausgeschalteten Position verriegelbar sein.

Die Wiederanlaufschutzeinrichtung kann eingerichtet sein, den Betriebsschalter abzutasten und bei betätigtem Betriebsschalter und unmittelbar nach einem erkannten Spannungsabfall, nachdem die Spannung wiederhergestellt wurde, ein Wiederanlaufen des Elektromotors blockieren. Alternativ zu einer Abtastung des Betriebsschalters kann allerdings auch vorgesehen sein, den Betriebszustand des Elektromotors vor dem Spannungsabfall zu erfassen bzw. festzustellen, ob der Elektromotor nach Wiederherstellung der Spannungsversorgung im Begriff ist anzulaufen oder nicht.

Die vorgeschlagene Wiederanlaufschutzvorrichtung kann besonders flexibel für nahezu alle erdenkbaren Varianten von elektrischen Einrichtungen, insbesondere Elektrowerkzeugmaschinen, einsetzbar sein. Die Wiederanlaufschutzvorrichtung kann insbesondere verlässlicher ausgebildet sein als die bekannten Wiederanlaufschutzvorrichtungen des Standes der Technik.

Die Erfindung betrifft auch ein Verfahren zur Erkennung eines Spannungsabfalls zwischen einem Anodenanschluss und einem Kathodenanschluss gemäß Anspruch 10.

Auf vorteilhafte Weise kann der Kontrollkondensator beispielsweise über ein Teilerverhältnis der Versorgungsspannung bzw. der Spannung zwischen dem Anodenanschluss und dem Kathodenanschluss geladen werden.

Es kann beispielsweise ein n-Kanal-MOSFET oder ein sonstiger Transistor bzw. gesteuerter Schalter parallel zu dem Kontrollkondensator geschaltet werden, um den Kontrollkondensator kontrolliert zu entladen.

Der Steuereingang bzw. der Gate-Anschluss des n-Kanal-MOSFETs kann mit einem akkuspannungsgekoppelten, ersten gesteuerten Schalter bzw. n-Kanal-MOSFET der Messeinrichtung verbunden sein. Wird dann die Versorgungsspannung abgetrennt, so wird schließlich der erste gesteuerte Schalter der Messeinrichtung nichtleitend und der zweite gesteuerte Schalter über einen Pullup-Widerstand auf ein leitendes Potential in Richtung Anodenanschluss gezogen, wodurch der Kontrollkondensator trotz des angeschlossenen Pufferkondensators, der selbst wie eine Versorgungsquelle wirken kann, entladen wird.

Wird beispielsweise ein Akkupack bei eingeschalteter elektrischer Einrichtung, also beispielsweise bei eingeschaltetem Elektromotor der Elektrowerkzeugmaschine, wieder aufgesteckt (Wiederanlaufschutzevent), so wird der zweite gesteuerte Schalter durch seine Verbindung des Steuergangs mit dem ersten gesteuerten Schalter wieder nichtleitend geschaltet. Der Kontrollkondensator vermag sich dann wieder über einen optionalen Ladewiderstand auf das definierte Teilerverhältnis der Versorgungsspannung aufzuladen. Dieses Ladeverhalten kann von der Steuereinrichtung überwacht und gegen ein weiteres Teilerverhältnis der Versorgungsspannung verglichen werden. Ist der Kontrollkondensator kleiner als die vorgesehene vollständige Ladung aufgeladen, gegebenenfalls unter Berücksichtigung gewisser Toleranzen, kann ein Spannungsabfall erkannt und beispielsweise ein Elektromotor nicht eingeschaltet werden.

Die Erfindung betrifft außerdem ein Computerprogramm gemäß Anspruch 11.

Die Erfindung betrifft auch eine Verwendung einer Vorrichtung gemäß den vorstehenden und nachfolgenden Ausführungen mit einer elektrischen Einrichtung, die einen Pufferkondensator zwischen dem Anodenanschluss und dem Kathodenanschluss aufweist, insbesondere einen hochkapazitiven Pufferkondensator ("Low-ESR"-Kondensator).

Die Erfindung betrifft außerdem eine vorteilhafte Verwendung einer Vorrichtung gemäß den vorstehenden und nachfolgenden Ausführungen mit einer elektrischen Einrichtung, insbesondere einer Elektrowerkzeugmaschine, die von mehreren Spannungsquellen, insbesondere von mehreren Akkupacks, betreibbar ist.

Besonders eignet sich die Erfindung zur Verwendung mit einer elektrischen Einrichtung, beispielsweise einer Elektrowerkzeugmaschine, mit externer Spannungsversorgung zur Bereitstellung der Spannung zwischen dem Anodenanschluss und dem Kathodenanschluss.

An dieser Stelle sei erwähnt, dass mit der vorstehenden und nachfolgenden Formulierung, wonach elektrische Komponenten mit anderen elektrischen Komponenten "verbunden" sind, jeweils eine mittelbare oder unmittelbare Verbindung gemeint sein kann. An der Verbindung können somit gegebenenfalls auch noch weitere elektrische Komponenten beteiligt sein, beispielsweise Widerstände, Spulen, Kondensatoren oder sonstige Bauelemente. Der Begriff "verbunden" kann gegebenenfalls auch im Sinne einer unmittelbaren elektrischen Verbindung durch den Begriff "angeschlossen" austauschbar sein.

Alle Widerstände im Rahmen der Erfindung können grundsätzlich auch aus entsprechenden Widerstandsnetzwerken und somit aus mehreren einzelnen elektrischen Widerständen zusammengesetzt sein. Dies gilt analog auch für alle weiteren elektrischen Bauteile, wie beispielsweise Kondensatoren. Die elektrische Zusammenschaltung einzelner elektrischer Bauteile zu einer größeren, gemeinsamen Einheit, ist dem Fachmann geläufig.

Merkmale, die im Zusammenhang mit einem der Gegenstände der Erfindung, namentlich gegeben durch die Vorrichtung, die Elektrowerkzeugmaschine, das Verfahren und das Computerprogramm beschrieben wurden, sind auch für die anderen Gegenstände der Erfindung vorteilhaft umsetzbar. Ebenso können Vorteile, die im Zusammenhang mit einem der Gegenstände der Erfindung genannt wurden, auch auf die anderen Gegenstände der Erfindung bezogen verstanden werden.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

In einer puristischen Ausführungsform der Erfindung kann allerdings auch vorgesehen sein, dass die in der Erfindung mit den Begriffen "umfassend", "aufweisend" oder "mit" eingeführten Merkmale abschließend aufgezählt sind. Dementsprechend kann eine oder können mehrere Aufzählungen von Merkmalen im Rahmen der Erfindung als abgeschlossen betrachtet werden, beispielsweise jeweils für jeden Anspruch betrachtet. Die Erfindung kann beispielsweise ausschließlich aus den in Anspruch 1 genannten Merkmalen bestehen.

Es sei erwähnt, dass Bezeichnungen wie "erstes" oder "zweites" etc. vornehmlich aus Gründen der Unterscheidbarkeit von jeweiligen Vorrichtungs- oder Verfahrensmerkmalen verwendet werden und nicht unbedingt andeuten sollen, dass sich Merkmale gegenseitig bedingen oder miteinander in Beziehung stehen.

Ferner sei betont, dass die vorliegend beschriebenen Werte und Parameter Abweichungen oder Schwankungen von ±10% oder weniger, vorzugsweise ±5% oder weniger, weiter bevorzugt ±1% oder weniger, und ganz besonders bevorzugt ±0,1% oder weniger des jeweils benannten Wertes bzw. Parameters mit einschließen, sofern diese Abweichungen bei der Umsetzung der Erfindung in der Praxis nicht ausgeschlossen sind. Die Angabe von Bereichen durch Anfangs- und Endwerte umfasst auch all diejenigen Werte und Bruchteile, die von dem jeweils benannten Bereich eingeschlossen sind, insbesondere die Anfangs- und Endwerte und einen jeweiligen Mittelwert.

Die nachfolgende Figur zeigt ein bevorzugtes Ausführungsbeispiel der Erfindung, in dem einzelne Merkmale der vorliegenden Erfindung in Kombination miteinander dargestellt sind. Merkmale des Ausführungsbeispiels sind auch losgelöst voneinander umsetzbar und können dementsprechend von einem Fachmann ohne Weiteres zu weiteren sinnvollen Kombinationen und Unterkombinationen verbunden werden.

Es zeigt schematisch:

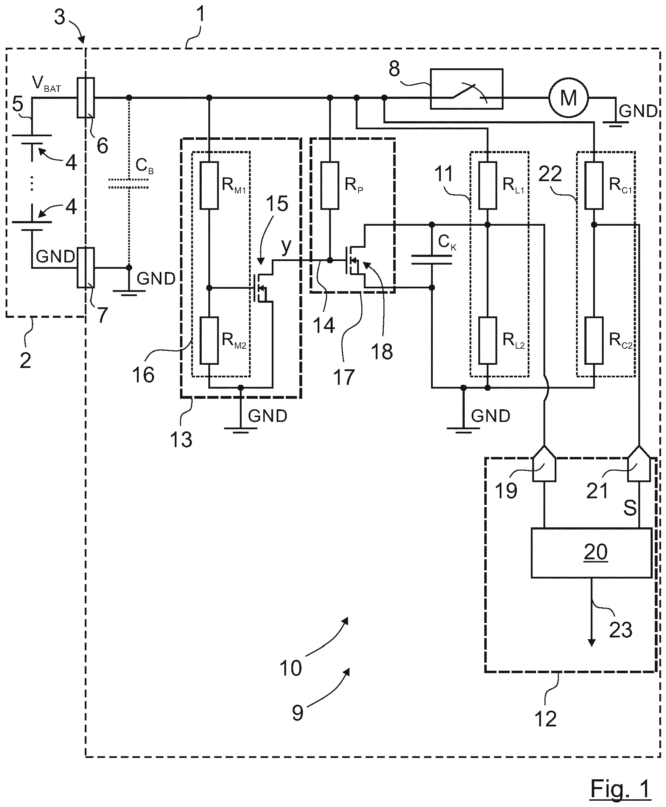

- Figur 1: ein Schaltbild einer akkubetriebene Elektrowerkzeugmaschine mit einer Vorrichtung zur Erkennung eines Spannungsabfalls im Rahmen einer Wiederanlaufschutzeinrichtung.

Figur 1 zeigt schematisch eine akkubetriebene Elektrowerkzeugmaschine 1 sowie ein mit der Elektrowerkzeugmaschine 1 verbundenes Akkupack 2 zur Bereitstellung einer Versorgungsspannung V_{BAT} für die Elektrowerkzeugmaschine 1.

Zur Verbindung des Akkupacks 2 mit der Elektrowerkzeugmaschine 1 weisen Akkupack 2 und Elektrowerkzeugmaschine 1 eine jeweilige Akkupackschnittstelle 3 auf. An dieser Stelle sei erwähnt, dass sich die Erfindung auch vorteilhaft zur Verwendung mit mehreren Akkupacks 2 eignen kann, um die bereitgestellte Versorgungsspannung V_{BAT} zu erhöhen und/oder um die Betriebsdauer bei der Verwendung der Elektrowerkzeugmaschine 1 zu erhöhen. Mehrere Akkupacks 2 können insbesondere in Serie verschaltet werden, grundsätzlich aber auch parallelgeschaltet sein.

Das Akkupack 2 kann eine oder mehrere Akkumulatorzellen 4 aufweisen, die beispielsweise in Reihe miteinander verbunden sind und insgesamt die Versorgungsspannung V_{BAT} erzeugen. Das dargestellte Akkupack 2 weist beispielhaft eine Versorgungsleitung 5 sowie eine Masseleitung GND auf, die über die Akkupackschnittstelle 3 zur Versorgung der Elektrowerkzeugmaschine 1 mit der Elektrowerkzeugmaschine 1 verbunden sind.

Die dargestellte Elektrowerkzeugmaschine 1 weist einen Anodenanschluss 6 und einen Kathodenanschluss 7 bzw. GND auf, zwischen denen die Versorgungsspannung V_{BAT} anliegt. Zum Ausgleich von Überspannungen ist zwischen dem Anodenanschluss 6 und dem Kathodenanschluss 7 ein Pufferkondensator C_{B} vorgesehen, insbesondere ein Elektrolytkondensator. Der Pufferkondensator C_{B} ist im Rahmen der Erfindung allerdings nicht unbedingt erforderlich; die Erfindung eignet sich jedoch besonders vorteilhaft zur Verwendung mit einer Elektrowerkzeugmaschine 1, die einen derartigen Pufferkondensator C_{B} aufweist.

Ferner weist die Elektrowerkzeugmaschine 1 einen Betriebsschalter 8 auf, um einen Elektromotor M der Elektrowerkzeugmaschine 1 wahlweise einzuschalten oder auszuschalten. Der Betriebsschalter 8 kann in seiner Einschaltstellung arretierbar sein.

Um ein unerwünschtes Wiederanlaufen des Elektromotors M, beispielsweise bei arretiertem Betriebsschalter 8, nach einem Spannungsabfall der Versorgungsspannung V_{BAT} zu verhindern, ist eine Wiederanlaufschutzeinrichtung 9 vorgesehen, die die nachfolgend noch beschriebene Vorrichtung 10 zur Erkennung des Spannungsabfalls zwischen dem Anodenanschluss 6 und dem Kathodenanschluss 7 aufweist.

Die Vorrichtung 10 zur Erkennung des Spannungsabfalls weist einen Kontrollkondensator C_{K} auf, dessen erste Elektrode mit dem Anodenanschluss 6 und dessen zweite Elektrode mit dem Kathodenanschluss 7 verbunden ist. Der Kontrollkondensator C_{K} wird somit im Falle eines in die Elektrowerkzeugmaschine 1 eingesetzten Akkupacks 2 bzw. bei vorhandener Versorgungsspannung V_{BAT} aufgeladen. Im Ausführungsbeispiel wird das Aufladen des Kontrollkondensators C_{K} durch die Verwendung eines vorgeschalteten, primären Ladewiderstands R_{L1} verzögert. Der primäre Ladewiderstand R_{L1} bildet mit einem sekundären Ladewiderstand R_{L2} einen ersten Spannungsteiler 11 aus und begrenzt somit außerdem die maximal erreichbare Ladespannung des Kontrollkondensators C_{K}. Der primäre Ladewiderstand R_{L1} kann beispielsweise derart dimensioniert sein, dass die nachfolgend noch beschriebene Steuereinrichtung 12 und/oder weitere elektrische Komponenten der Elektrowerkzeugmaschine 1 ausreichend Zeit für einen Bootvorgang haben, um ein Wiederanlaufschutzevent sicher zu erkennen. Die Verwendung eines primären Ladewiderstands R_{L1} bzw. des ersten Spannungsteilers 11 ist grundsätzlich optional.

Der primäre Ladewiderstand R_{L1} kann beispielsweise 470 kΩ und der sekundäre Ladewiderstand 27 kΩ betragen, wenn die Versorgungsspannung V_{BAT} nominal 36 Volt beträgt (beispielsweise durch zwei seriell verschaltete Akkupacks 2 bereitgestellt). Der primäre Ladewiderstand R_{L1} kann beispielsweise 240 kΩ und der sekundäre Ladewiderstand 27 kΩ betragen, wenn die Versorgungsspannung V_{BAT} nominal 18 Volt oder 10,8 Volt beträgt (beispielsweise durch ein einzelnes Akkupack 2 bereitgestellt).

Die Kapazität des Kontrollkondensators C_{K} kann beispielsweise 2 µF betragen. Es kann eine beliebige Bauart vorgesehen sein.

Die vorgeschlagene Vorrichtung 10 weist eine Messeinrichtung 13 auf, die eingerichtet ist, ein Entladesignal y in Abhängigkeit einer zwischen dem Anodenanschluss 6 und dem Kathodenanschluss 7 erfasste Potentialdifferenz und einem ersten Schwellenwert für die Potentialdifferenz auf einer Entladesteuerleitung 14 auszugeben.

Die Messeinrichtung 13 weist hierzu einen ersten gesteuerten Schalter 15 auf, der im Ausführungsbeispiel als n-Kanal-MOSFET ausgebildet ist. Der Steuereingang bzw. der Gate-Anschluss des ersten Schalters 15 ist über einen zweiten Spannungsteiler 16 mit dem Anodenanschluss 6 verbunden. Der erste Schalter 15 ist ausgebildet, die Entladesteuerleitung 14 niederohmig mit dem Kathodenanschluss 7 zu verbinden, wenn das an dem Steuereingang anliegende Eingangspotential den ersten Schwellenwert überschreitet. Im Normalzustand, also bei ausreichender Spannungsversorgung, ist die Entladesteuerleitung 14 somit mit dem Kathodenanschluss 7 niederohmig verbunden. Bei Unterschreitung des ersten Schwellenwerts, also bei einem Spannungsabfall der Versorgungsspannung V_{BAT}, wird die Entladesteuerleitung 14 hingegen potentialfrei geschaltet, was im Ausführungsbeispiel dem Entladesignal y entspricht.

Die Vorrichtung kann durch Dimensionierung des ersten Schalters 15 und des zweiten Spannungsteilers 16 flexibel konfiguriert und beispielsweise zur Verwendung mit dem Pufferkondensator C_{B} angepasst werden. Der erste Schwellenwert kann beispielsweise 10% bis 90% der nominalen Versorgungsspannung V_{BAT} betragen, vorzugsweise 20% bis 80% und besonders bevorzugt 30% bis 70%. Das Teilerverhältnis des zweiten Spannungsteilers 16 kann vorzugsweise so ausgelegt sein, dass der erste Schalter 15 die Entladesteuerleitung 14 noch vor der maximalen Restentladung (beispielsweise 5 Volt bei einer Versorgungsspannung V_{BAT} von 36 Volt oder 4,3 Volt bei einer Versorgungsspannung V_{BAT} von 18 Volt oder 10,8 Volt) des Pufferkondensators C_{B} potentialfrei schaltet, wobei gleichzeitig der zulässige Betriebsbereich der Elektrowerkzeugmaschine (beispielsweise 30 Volt bis 42 Volt bei einer Versorgungsspannung V_{BAT} von 36 Volt, 15 Volt bis 21 Volt bei einer Versorgungsspannung V_{BAT} von 18 Volt oder 9 Volt bis 12,6 Volt bei einer Versorgungsspannung V_{BAT} von 10,8 Volt) berücksichtigt wird.

Beispielsweise kann die Restentladung des Pufferkondensators C_{B} bei einer Nominalbetriebsspannung von 10,8 Volt oder 18 Volt bis zu 4,3 Volt betragen. In diesem Fall kann vorgesehen sein, dass das Schalten des ersten Schalters 15 bei einer erfassten Potentialdifferenz ab 9,33 Volt abwärts beginnt und spätestens bei einem Restpotential von 5,73 Volt eine vollständige Trennung der Entladesteuerleitung 14 von dem Kathodenanschluss 7 erfolgt ist. Der dargestellte, an dem Anodenanschluss 6 angeschlossene primäre Widerstand R_{M1} des zweiten Spannungsteilers 16 kann somit beispielsweise 2,33 MΩ und der an den Kathodenanschluss 7 angeschlossene, sekundäre Widerstand R_{M2} des zweiten Spannungsteilers 16 1,0 MΩ betragen.

Gemäß einem weiteren Beispiel kann die Restentladung des Pufferkondensators C_{B} bei einer Nominalbetriebsspannung von 36 Volt bis zu 5,0 Volt betragen. In diesem Fall kann vorgesehen sein, dass das Schalten des ersten Schalters 15 bei einer erfassten Potentialdifferenz ab 26 Volt abwärts beginnt und spätestens bei einem Restpotential von 16 Volt eine vollständige Trennung der Entladesteuerleitung 14 von dem Kathodenanschluss 7 erfolgt ist. Der dargestellte, an dem Anodenanschluss 6 angeschlossene primäre Widerstand R_{M1} des zweiten Spannungsteilers 16 kann somit beispielsweise 4,0 MΩ und der an den Kathodenanschluss 7 angeschlossene, sekundäre Widerstand R_{M2} des zweiten Spannungsteilers 16 470 kΩ betragen.

Die vorgeschlagene Vorrichtung 10 weist ferner eine zur Entladung des Kontrollkondensators C_{K} ausgebildete steuerbare Entladeschaltung 17 auf. Die Entladeschaltung 17 ist mit der Entladesteuerleitung 14 zum Empfang des Entladesignals y verbunden und eingerichtet, um den Kontrollkondensator C_{K} in Abhängigkeit des Entladesignals y zu entladen.

Beispielsweise kann vorgesehen sein, dass die Entladeschaltung 17 eine hochohmige Verbindung zwischen den beiden Elektroden des Kontrollkondensators C_{K} herstellt, wenn ein Steuereingang der Entladeschaltung 17 auf das Potential des Kathodenanschlusses 7 geschaltet ist, und andernfalls eine niederohmige Verbindung zwischen den Elektroden des Kontrollkondensators C_{K} herstellt.

Wie dargestellt, kann die Entladeschaltung 17 hierzu einen zweiten gesteuerten Schalter 18 aufweisen, im Ausführungsbeispiel ein weiterer n-Kanal-MOSFET. Der Steuereingang des zweiten Schalters 18 kann mit der Entladesteuerleitung 14 verbunden sein, optional über einen Serienwiderstand (nicht dargestellt) von beispielsweise 47 kΩ.

Insofern die Entladesteuerleitung 14 im Normalbetrieb durch die Messeinrichtung 13 auf das Potential des Kathodenanschlusses 7 gezogen wird, ist der zweite Schalter 18 ausgangsseitig hochohmig. Liegt hingegen das Entladesignal y auf der Entladesteuerleitung 14 an, was im Ausführungsbeispiel einer Potentialfreiheit der Entladesteuerleitung 14 seitens des ersten Schalters 15 gleichkommt, so wird der Steuereingang des zweiten Schalters 18 über den in Figur 1 dargestellten Pullup-Widerstand R_{P} mit dem Anodenanschluss 6 verbunden. Der Pullup-Widerstand R_{P} kann beispielsweise 4,7 MΩ betragen.

Auf diese Weise wird der Kontrollkondensator C_{K} durch die Entladeschaltung 17 kurzgeschlossen, wenn die Messeinrichtung 13 einen Spannungsabfall der Versorgungsspannung V_{BAT} feststellt. Der Kontrollkondensator C_{K} entlädt sich somit. Dies erfolgt selbst bei vorhandenem Pufferkondensator C_{B} und auch dann, wenn bei Verwendung mehrerer Akkupacks 2 nur ein Teil der Akkupacks 2 mit der Elektrowerkzeugmaschine 1 verbunden ist.

Schließlich weist die vorgeschlagene Vorrichtung 10 eine Steuereinrichtung 12 auf, die eingerichtet ist, um den Spannungsabfall durch Auswertung des Ladezustands des Kontrollkondensators C_{K} zu erkennen. Die Steuereinrichtung 12 ist vorzugsweise digital ausgebildet, beispielsweise als Mikrokontroller der Elektrowerkzeugmaschine 1. Auf der Steuereinrichtung 12 kann ein entsprechend geeignetes Computerprogramm mit Steuerbefehlen ausgeführt werden, die die Steuereinrichtung 12 dazu veranlassen, das vorgeschlagene Verfahren auszuführen.

Zur Erfassung des Ladezustands durch die Steuereinrichtung 12 kann der Steuereinrichtung 12 beispielsweise die im Nominalfall mit dem Anodenanschluss 6 verbundene erste Elektrode des Kontrollkondensators C_{K} zugeführt werden, insbesondere über einen ersten Analog-Digital-Wandler 19.

Die Steuereinrichtung 12 kann eine Komparatoreinheit 20 aufweisen die eingerichtet ist, um den Ladezustand des Kontrollkondensators C_{K} mit einem zweiten Schwellenwert S für die Potentialdifferenz zwischen dem Anodenanschluss 6 und dem Kathodenanschluss 7 zu vergleichen. Der Spannungsabfall wird vorzugsweise erkannt, wenn der Ladezustand des Kontrollkondensators C_{K} kleiner ist als der zweite Schwellenwert S, da dann davon ausgegangen werden kann, dass sich der Kontrollkondensator C_{K} unlängst entladen hat.

Der zweite Schwellenwert S kann der Steuereinrichtung 12 optional über einen zweiten Analog-Digital-Wandler 21 zugeführt werden, und kann sich beispielsweise in Abhängigkeit der tatsächlichen Versorgungsspannung V_{BAT} als Teilerverhältnis der Versorgungsspannung V_{BAT} ergeben, beispielsweise anhand eines dritten Spannungsteilers 22 im Verhältnis R_{C1} = 470 kΩ zu R_{C2} = 27 kΩ (bei einer nominalen Versorgungsspannung V_{BAT} von 36 Volt) oder R_{C1} = 240 kΩ zu R_{C2} = 27 kΩ (bei einer nominalen Versorgungsspannung V_{BAT} von 18 Volt oder 10,8 Volt). Vorzugsweise entspricht das Teilerverhältnis des dritten Spannungsteilers 22 dem Teilerverhältnis des ersten Spannungsteilers 11, besonders bevorzugt sind die Widerstände des ersten Spannungsteilers 11 und des dritten Spannungsteilers 22 so gewählt, dass gilt: R_{L1} = R_{C1} und R_{L2} = R_{C2}.

Bei erkanntem Spannungsabfall kann die Steuereinrichtung 12 ein Steuersignal 23 bereitstellen, wobei die Wiederanlaufschutzeinrichtung 9 das Anlaufen des Elektromotors M in Abhängigkeit des Steuersignals 23 wahlweise blockiert oder freigibt.

## Patentansprüche

1. Vorrichtung (10) zur Erkennung eines Spannungsabfalls zwischen einem Anodenanschluss (6) und einem Kathodenanschluss (7), aufweisend
- einen Kontrollkondensator (C_{K}), dessen erste Elektrode mit dem Anodenanschluss (6) und dessen zweite Elektrode mit dem Kathodenanschluss (7) verbindbar ist;
- eine Messeinrichtung (13), die eingerichtet ist, ein Entladesignal (y) in Abhängigkeit einer zwischen dem Anodenanschluss (6) und dem Kathodenanschluss (7) erfassten Potentialdifferenz und einem ersten Schwellenwert für die Potentialdifferenz auf einer Entladesteuerleitung (14) auszugeben;
- eine mit der Entladesteuerleitung (14) verbundene Entladeschaltung (17), die eingerichtet ist, den Kontrollkondensator (C_{K}) in Abhängigkeit von dem Entladesignal (y) zu entladen; und
- eine Steuereinrichtung (12), die eingerichtet ist, um den Spannungsabfall durch Auswertung des Ladezustands des Kontrollkondensators (C_{K}) zu erkennen, wobei
die Entladeschaltung (17) einen zweiten gesteuerten Schalter (18) aufweist, dessen Steuereingang mit der Entladesteuerleitung (14) verbunden ist, und der ausgebildet ist, die erste Elektrode des Kontrollkondensators (C_{K}) niederohmig mit der zweiten Elektrode des Kontrollkondensators (C_{K}) zu verbinden, wenn die Entladesteuerleitung (14) von dem Kathodenanschluss (7) getrennt ist, und wobei der Steuereingang des zweiten gesteuerten Schalters (18) über einen Pullup-Widerstand (R_{P}) mit dem Anodenanschluss (6) verbindbar ist,
**dadurch gekennzeichnet, dass** die Messeinrichtung (13) einen ersten gesteuerten Schalter (15) aufweist, dessen Steuereingang über einen zweiten Spannungsteiler (16) mit dem Anodenanschluss (6) verbindbar ist, und der ausgebildet ist, die Entladesteuerleitung (14) niederohmig mit dem Kathodenanschluss (7) zu verbinden, wenn das an dem Steuereingang anliegende Eingangspotential den ersten Schwellenwert überschreitet, wobei der erste gesteuerte Schalter (15) ausgebildet ist, die Entladesteuerleitung (14) von dem Kathodenanschluss (7) zu trennen, wenn das an dem Steuereingang anliegende Eingangspotential den ersten Schwellenwert unterschreitet.

2. Vorrichtung (10) nach Anspruch 1,
**dadurch gekennzeichnet, dass** der Anodenanschluss (6) und/oder der Kathodenanschluss (7) mit korrespondierenden Versorgungsanschlüssen einer externen Spannungsquelle verbindbar sind, insbesondere mit den Versorgungsanschlüssen eines oder mehrerer Akkupacks (2).

3. Vorrichtung (10) nach Anspruch 1 oder 2,
**dadurch gekennzeichnet, dass** die erste Elektrode des Kontrollkondensators (C_{K}) über einen ersten Spannungsteiler (11) mit dem Anodenanschluss (6) verbunden ist.

4. Vorrichtung (10) nach einem der Ansprüche 1 bis 3,
**dadurch gekennzeichnet, dass** der erste Schwellenwert 10% bis 90% der nominalen Potentialdifferenz zwischen dem Anodenanschluss (6) und dem Kathodenanschluss (7) beträgt, vorzugsweise 20% bis 80% beträgt und besonders bevorzugt 30% bis 70% beträgt.

5. Vorrichtung (10) nach einem der Ansprüche 1 bis 4,
**dadurch gekennzeichnet, dass** der erste gesteuerte Schalter (15) und/oder der zweite gesteuerte Schalter (18) als Halbleiterschalter, insbesondere als MOSFET, vorzugsweise als n-Kanal-MOSFET ausgebildet ist.

6. Vorrichtung (10) nach einem der Ansprüche 1 bis 5,
**dadurch gekennzeichnet, dass** die Steuereinrichtung (12) eine Komparatoreinheit (20) aufweist, die eingerichtet ist, um den Ladezustand des Kontrollkondensators (C_{K}) mit einem zweiten Schwellenwert (S) für die Potentialdifferenz zwischen dem Anodenanschluss (6) und dem Kathodenanschluss (7) zu vergleichen, wobei der Spannungsabfall erkannt wird, wenn der Ladezustand kleiner ist als der zweite Schwellenwert (S).

7. Vorrichtung (10) nach Anspruch 6,
**dadurch gekennzeichnet, dass** der zweite Schwellenwert (S) 1% bis 95% der nominalen Potentialdifferenz zwischen dem Anodenanschluss (6) und dem Kathodenanschluss (7) beträgt, vorzugsweise 75% bis 50% beträgt, beispielsweise 5% bis 10% beträgt.

8. Elektrowerkzeugmaschine (1), insbesondere akkubetriebene Elektrowerkzeugmaschine (1), aufweisend einen Anodenanschluss (6) und einen Kathodenanschluss (7) zur elektrischen Versorgung, sowie eine Vorrichtung (10) nach einem der Ansprüche 1 bis 7 zur Erkennung eines Spannungsabfalls zwischen dem Anodenanschluss (6) und dem Kathodenanschluss (7).

9. Elektrowerkzeugmaschine (1) nach Anspruch 8,
**gekennzeichnet durch** eine Wiederanlaufschutzeinrichtung (9) zum Schutz eines unkontrollierten Wiederanlaufens der Elektrowerkzeugmaschine (1) nach einem Spannungsabfall, wobei die Wiederanlaufschutzeinrichtung (9) zur Erkennung des Spannungsabfalls mit der Vorrichtung (10) kommunikationsverbunden ist.

10. Verfahren zur Erkennung eines Spannungsabfalls zwischen einem Anodenanschluss (6) und einem Kathodenanschluss (7), wonach zur Erkennung des Spannungsabfalls der Ladezustand eines Kontrollkondensator (C_{K}) ausgewertet wird, dessen erste Elektrode mit dem Anodenanschluss (6) und dessen zweite Elektrode mit dem Kathodenanschluss (7) verbunden ist, wobei eine Messeinrichtung (13) ein Entladesignal (y) in Abhängigkeit einer zwischen dem Anodenanschluss (6) und dem Kathodenanschluss (7) erfassten Potentialdifferenz und einem ersten Schwellenwert für die Potentialdifferenz auf einer Entladesteuerleitung (14) ausgibt, und eine mit der Entladesteuerleitung (14) verbundene Entladeschaltung (17) den Kontrollkondensator (C_{K}) in Abhängigkeit von dem Entladesignal (y) entlädt, wobei die Entladeschaltung (17) einen zweiten gesteuerten Schalter (18) aufweist, dessen Steuereingang mit der Entladesteuerleitung (14) verbunden ist, und der die erste Elektrode des Kontrollkondensators (C_{K}) niederohmig mit der zweiten Elektrode des Kontrollkondensators (C_{K}) verbindet, wenn die Entladesteuerleitung (14) von dem Kathodenanschluss (7) getrennt ist, und wobei der Steuereingang des zweiten gesteuerten Schalters (18) über einen Pullup-Widerstand (R_{P}) mit dem Anodenanschluss (6) verbunden ist,
**dadurch gekennzeichnet, dass** die Messeinrichtung (13) einen ersten gesteuerten Schalter (15) aufweist, dessen Steuereingang über einen zweiten Spannungsteiler (16) mit dem Anodenanschluss (6) verbunden ist, und der die Entladesteuerleitung (14) niederohmig mit dem Kathodenanschluss (7) verbindet, wenn das an dem Steuereingang anliegende Eingangspotential den ersten Schwellenwert überschreitet, wobei der erste gesteuerte Schalter (15) die Entladesteuerleitung (14) von dem Kathodenanschluss (7) trennt, wenn das an dem Steuereingang anliegende Eingangspotential den ersten Schwellenwert unterschreitet.

11. Computerprogramm, umfassend Steuerbefehle, die bei der Ausführung des Programms durch eine Steuereinrichtung (12) die Vorrichtung nach einem der Ansprüche 1 bis 7 veranlasst, das Verfahren gemäß Anspruch 10 auszuführen.

## Claims

1. A device (10) for detecting a voltage drop between an anode connection (6) and a cathode connection (7), comprising
- a control capacitor (C_{K}), of which the first electrode is connectable to the anode connection (6) and the second electrode is connectable to the cathode connection (7);
- a measuring device (13), which is designed to output a discharge signal (y) depending on a potential difference, which is detected between the anode connection (6) and the cathode connection (7), and a first threshold value for the potential difference on a discharge control line (14);
- a discharge circuit (17), which is connected to the discharge control line (14) and is designed to discharge the control capacitor (C_{K}) depending on the discharge signal (y); and
- a control device (12), which is designed to detect the voltage drop by evaluating the state of charge of the control capacitor (C_{K}), wherein
the discharge circuit (17) includes a second controlled switch (18), of which the control input is connected to the discharge control line (14) and which is designed to connect the first electrode of the control capacitor (C_{K}) with low impedance to the second electrode of the control capacitor (C_{K}) when the discharge control line (14) is disconnected from the cathode connection (7), and wherein the control input of the second controlled switch (18) is connectable to the anode connection (6) via a pull-up resistor (R_{P}),
**characterized in that** the measuring device (13) includes a first controlled switch (15), of which the control input is connectable to the anode connection (6) via a second voltage divider (16) and which is designed to connect the discharge control line (14) to the cathode connection (7) with low impedance when the input potential applied at the control input exceeds the first threshold value, wherein the first controlled switch (15) is designed to disconnect the discharge control line (14) from the cathode connection (7) when the input potential applied at the control input drops below the first threshold value.

2. The device (10) according to claim 1,
**characterized in that** the anode connection (6) and/or the cathode connection (7) are/is connectable to corresponding supply terminals of an external voltage source, more particularly to the supply terminals of one or multiple rechargeable battery pack(s) (2).

3. The device (10) according to claim 1 or 2,
**characterized in that** the first electrode of the control capacitor (C_{K}) is connected to the anode connection (6) via a first voltage divider (11).

4. The device (10) according to one of claims 1 through 3,
**characterized in that** the first threshold value is 10% to 90% of the nominal potential difference between the anode connection (6) and the cathode connection (7), preferably 20% to 80% and particularly preferably 30% to 70%.

5. The device (10) according to one of claims 1 through 4,
**characterized in that** the first controlled switch (15) and/or the second controlled switch (18) are/is designed as a semiconductor switch, more particularly as MOSFET, preferably as n-channel MOSFET.

6. The device (10) according to one of claims 1 through 5,
**characterized in that** the control device (12) has a comparator unit (20), which is designed to compare the state of charge of the control capacitor (C_{K}) with a second threshold value (S) for the potential difference between the anode connection (6) and the cathode connection (7), wherein the voltage drop is detected when the state of charge is lower than the second threshold value (S).

7. The device (10) according to claim 6,
**characterized in that** the second threshold value (s) is 1% to 95% of the nominal potential difference between the anode connection (6) and the cathode connection (7), preferably 75% to 50% and particularly preferably 5% to 10%.

8. An electrical machine tool (1), more particularly a battery-operated electrical machine tool (1), including an anode connection (6) and a cathode connection (7) for electrical supply, and a device (10) according to one of claims 1 through 7 for detecting a voltage drop between the anode connection (6) and the cathode connection (7).

9. The electrical machine tool (1) according to claim 8,
**characterized by** a restart protection device (9) for protection against an uncontrolled restart of the electrical machine tool (1) after a voltage drop, wherein the restart protection device (9) is connected to the device (10) for communication purposes for the purpose of detecting the voltage drop.

10. A method for detecting a voltage drop between an anode connection (6) and a cathode connection (7), whereupon the state of charge of a control capacitor (C_{K}) is evaluated in order to detect the voltage drop, the first electrode of the control capacitor being connected to the anode connection (6) and the second electrode of the control capacitor (C_{K}) being connected to the cathode connection (7), wherein a measuring device (13) outputs a discharge signal (y) on a discharge control line (14), depending on a potential difference, which is detected between the anode connection (6) and the cathode connection (7), and a first threshold value for the potential difference, and a discharge circuit (17) connected to the discharge control line (14) discharges the control capacitor (C_{K}) depending on the discharge signal (y), wherein the discharge circuit (17) includes a second controlled switch (18), of which the control input is connected to the discharge control line (14) and which connects the first electrode of the control capacitor (C_{K}) with low impedance to the second electrode of the control capacitor (C_{K}) when the discharge control line (14) is disconnected from the cathode connection (7), and wherein the control input of the second controlled switch (18) is connected to the anode connection (6) via a pull-up resistor (R_{P}),
**characterized in that** the measuring device (13) includes a first controlled switch (15), of which the control input is connected to the anode connection (6) via a second voltage divider (16) and which connects the discharge control line (14) to the cathode connection (7) with low impedance when the input potential applied at the control input exceeds the first threshold value, wherein the first controlled switch (15) disconnects the discharge control line (14) from the cathode connection (7) when the input potential applied at the control input drops below the first threshold value.

11. A computer program, including control commands which, when the program is run by a control device (12), prompt the device according to any of claims 1 to 7 to carry out the method according to claim 10.

## Revendications

1. Dispositif (10) pour détecter une chute de tension entre une borne d'anode (6) et une borne de cathode (7), comprenant
- un condensateur de contrôle (C_{K}) dont la première électrode peut être reliée à la borne d'anode (6) et dont la deuxième électrode peut être reliée à la borne de cathode (7) ;
- un dispositif de mesure (13) conçu pour émettre un signal de décharge (y) sur une ligne de commande de décharge (14) en fonction d'une différence de potentiel détectée entre la borne d'anode (6) et la borne de cathode (7) et d'une première valeur de seuil pour la différence de potentiel ;
- un circuit de décharge (17) relié à la ligne de commande de décharge (14), conçu pour décharger le condensateur de contrôle (C_{K}) en fonction du signal de décharge (y) ; et
- un dispositif de commande (12) conçu pour détecter la chute de tension en évaluant l'état de charge du condensateur de contrôle (C_{K}), dans lequel
le circuit de décharge (17) comporte un deuxième commutateur commandé (18) dont l'entrée de commande est reliée à la ligne de commande de décharge (14) et conçu pour relier la première électrode du condensateur de contrôle (C_{K}) à basse impédance à la deuxième électrode du condensateur de contrôle (C_{K}) lorsque la ligne de commande de décharge (14) est déconnectée de la borne de cathode (7), et dans lequel l'entrée de commande du deuxième commutateur commandé (18) peut être connectée à la borne d'anode (6) par l'intermédiaire d'une résistance Pullup (R_{P}),
**caractérisé en ce que** le dispositif de mesure (13) présente un premier commutateur commandé (15) dont l'entrée de commande peut être reliée à la borne d'anode (6) par l'intermédiaire d'un deuxième diviseur de tension (16), et est conçu pour relier la ligne de commande de décharge (14) à basse impédance à la borne de cathode (7) lorsque le potentiel d'entrée appliqué à l'entrée de commande dépasse la première valeur de seuil, dans lequel le premier commutateur commandé (15) est conçu pour déconnecter la ligne de commande de décharge (14) de la borne de cathode (7) lorsque le potentiel d'entrée appliqué à l'entrée de commande passe en dessous de la première valeur de seuil.

2. Dispositif (10) selon la revendication 1, **caractérisé en ce que** la borne d'anode (6) et/ou la borne de cathode (7) peuvent être connectées à des bornes d'alimentation correspondantes d'une source de tension externe, en particulier aux bornes d'alimentation d'un ou plusieurs blocs de batteries (2).

3. Dispositif (10) selon la revendication 1 ou 2, **caractérisé en ce que** la première électrode du condensateur de contrôle (C_{K}) est reliée à la borne d'anode (6) par l'intermédiaire d'un premier diviseur de tension (11).

4. Dispositif (10) selon l'une des revendications 1 à 3, **caractérisé en ce que** la première valeur de seuil est comprise entre 10 % et 90 % de la différence de potentiel nominale entre la borne d'anode (6) et la borne de cathode (7), de préférence entre 20 % et 80 %, et plus particulièrement entre 30 % et 70 %.

5. Dispositif (10) selon l'une des revendications 1 à 4, **caractérisé en ce que** le premier commutateur commandé (15) et/ou le deuxième commutateur commandé (18) est conçu comme un commutateur à semi-conducteur, en particulier comme un MOSFET, de préférence comme un MOSFET à canal n.

6. Dispositif (10) selon l'une des revendications 1 à 5, **caractérisé en ce que** le dispositif de commande (12) comporte une unité de comparaison (20) qui est conçue pour comparer l'état de charge du condensateur de contrôle (C_{K}) avec une deuxième valeur de seuil (S) pour la différence de potentiel entre la borne d'anode (6) et la borne de cathode (7), la chute de tension étant détectée lorsque l'état de charge est inférieur à la deuxième valeur seuil (S).

7. Dispositif (10) selon la revendication 6, **caractérisé en ce que** la deuxième valeur de seuil (S) est comprise entre 1 % et 95 % de la différence de potentiel nominale entre la borne d'anode (6) et la borne de cathode (7), de préférence entre 75 % et 50 %, par exemple entre 5 % et 10 %.

8. Machine-outil électrique (1), en particulier machine-outil électrique alimentée par batterie (1), comprenant une borne d'anode (6) et une borne de cathode (7) pour l'alimentation électrique, ainsi qu'un dispositif (10) selon l'une des revendications 1 à 7 pour détecter une chute de tension entre la borne d'anode (6) et la borne de cathode (7).

9. Machine-outil électrique (1) selon la revendication 8, **caractérisée par** un dispositif de protection contre le redémarrage (9) pour protéger la machine-outil électrique (1) contre un redémarrage incontrôlé après une chute de tension, dans laquelle le dispositif de protection contre le redémarrage (9) est relié au dispositif (10) pour détecter la chute de tension.

10. Procédé de détection d'une chute de tension entre une borne d'anode (6) et une borne de cathode (7), dans lequel l'état de charge d'un condensateur de contrôle (C_{K}) est évalué pour détecter la chute de tension, la première électrode de ce condensateur étant reliée à la borne d'anode (6) et la deuxième électrode à la borne de cathode (7), un dispositif de mesure (13) émettant un signal de décharge (y) sur une ligne de commande de décharge (14) en fonction d'une différence de potentiel détectée entre la borne d'anode (6) et la borne de cathode (7) et d'une première valeur de seuil pour la différence de potentiel, et un circuit de décharge (17) relié à la ligne de commande de décharge (14) décharge le condensateur de contrôle (C_{K}) en fonction du signal de décharge (y), le circuit de décharge (17) comportant un deuxième commutateur commandé (18) dont l'entrée de commande est reliée à la ligne de commande de décharge (14), et qui relie la première électrode du condensateur de contrôle (C_{K}) à basse impédance à la deuxième électrode du condensateur de contrôle (C_{K}) lorsque la ligne de commande de décharge (14) est déconnectée de la borne de cathode (7), et dans lequel l'entrée de commande du deuxième commutateur commandé (18) est reliée à la borne d'anode (6) par l'intermédiaire d'une résistance Pullup (R_{P}), **caractérisé en ce que** le dispositif de mesure (13) comporte un premier commutateur commandé (15) dont l'entrée de commande est reliée à la borne d'anode (6) par l'intermédiaire d'un deuxième diviseur de tension (16), et qui relie la ligne de commande de décharge (14) à basse impédance à la borne de cathode (7) lorsque le potentiel d'entrée appliqué à l'entrée de commande dépasse la première valeur de seuil, le premier commutateur commandé (15) déconnectant la puissance de commande de décharge (14) de la connexion de cathode (7) lorsque le potentiel d'entrée appliqué à l'entrée de commande passe en dessous de la première valeur de seuil.

11. Programme informatique comprenant des instructions de commande qui, lors de l'exécution du programme par un dispositif de commande (12), amènent le dispositif selon l'une des revendications 1 à 7 à exécuter le procédé selon la revendication 10.
